# EUROPEAN PATENT SPECIFICATION

(11) **EP 1 151 155 B1**
(45) Date of publication and mention of the grant of the patent: **16.04.2003**
(21) Application number: 00905501.3
(22) Date of filing: 18.01.2000
(51) Int. Cl.: C30B 29/36, C30B 25/00

(54) **CDV METHOD OF AND REACTOR FOR SILICON CARBIDE MONOCRYSTAL GROWTH**
VERFAREN UND REAKTOR ZUR ZÜCHTUNG VON SILIZIUM-KARBID EINKRISTALLUNG DURCH CHEMISCHE DAMPFABSCHEIDUNG
PROCEDE DE DEPOSITION CHIMIQUE EN PHASE VAPEUR ET REACTEUR POUR LA CROISSANCE DU MONOCRISTAL DE CARBIDE DE SILICIUM

(30) Priority: 21.01.1999 RU 99101816
(43) Date of publication of application: 07.11.2001
(73) Proprietor: Makarov, Jury Nikolaevich, St. Petersburg, 97198 (RU)
(72) Inventor: Makarov, Jury Nikolaevich, St. Petersburg, 97198 (RU)
(74) Representative: Andrae, Steffen, Dr.
(86) International application number: RU0000016
(87) International publication number: WO00043577

(56) References cited:
- EP-A- 0 554 047
- WO-A-97/01658
- WO-A-98/14644
- US-A- 5 964 944
- SUMAKERIS J J ET AL: "LAYER-BY-LAYER GROWTH OF SIC AT LOW TEMPERATURES" THIN SOLID FILMS,CH,ELSEVIER-SEQUOIA S.A. LAUSANNE, vol. 225, no. 1 / 02, 25 March 1993 (1993-03-25), pages 219-224, XP000358312 ISSN: 0040-6090
- YOSHINOBU T ET AL: "ATOMIC LEVEL CONTROL IN GAS SOURCE MBE GROWTH OF CUBIC SIC" JOURNAL OF CRYSTAL GROWTH,NL,NORTH-HOLLAND PUBLISHING CO. AMSTERDAM, vol. 99, no. 1/04, PART 01, 1 January 1990 (1990-01-01), pages 520-524, XP000117478 ISSN: 0022-0248

## Description

### FIELD OF THE INVENTION

The invention relates to generation of monocrystalline semiconductor materials, such as silicon carbide (SiC), and can be used in the production of semiconductor devices capable of operating at, elevated temperatures.

Specifically, the present invention concerns epitaxial growth of semiconductor single crystals by a chemical vapor deposition technique referred to in the special literature on the subject, as the CVD-method.

### BACKGROUND OF THE INVENTION

The CVD-method is essentially a technique of deposition of epitaxial layers of the material to be grown as a result of a chemical reaction of a mixture of gaseous reagents occurring at a high temperature. The material generally employed in CVD-reactors for growing monocrystalline silicon carbide (SiC) is a hydrogen (H₂) diluted mixture of gaseous reagents comprising silicon and carbon, respectively, namely, silane (SiH₄) and propane (C₃H₈).

An appropriately proportioned mixture of reagents is supplied to the growth zone of the reactor. Silicon carbide is generated at a temperature above 1400°C, beginning from which there occur reagent molecule disintegration and reaction of Sic formation out of the vapor phase of free silicon and carbon on the growing surface.

The heating is performed by an induction heater with its susceptor generally made of graphite.

Known in the art are different reactor designs allowing thin (i.e. of a thickness up to 50µ monocrystalline silicon carbide films to be grown within a temperature range of 1400°C to 1600°C, their quality being adequate to produce. based thereon, semiconductor electron devices. These reactors provide a layer thickness growth rate of several microns per hour, making them unsuitable for growing bulk single crystals necessary to start industrial production of semiconductor devices based on silicon carbide.

Known in the art is a sublimation method of growing bulk Sic single crystals described in an International Publication WO 97/27350 of International Application PCT/RU97/00005. like all other sublimation techniques, this method requires for its implementation a relatively expensive, precleaned, source material.

The method and device for epitaxial growth using CVD, which comes closest to the present invention, are those described in an International Publication WO 97/01658 of the International Application PCT/SE96/00822. The device is a vertical type reactor comprising a cylinder shaped graphite chamber with a substrate mounted therein, heated by an induction heater. The epitaxial growth of silicon carbide is carried out at high temperatures, within a range of 2000°C to 2500°C, allowing high growth rates and essentially permitting bulk single crystals to be grown. However the method and device according to the prior art, particularly in the event of growing bulk single crystals, require, after the growing process is finished, the inner space of the chamber to be cleaned to remove silicon carbide deposits nonuniformly precipitated onto the walls, and the chamber to be subsequently recoated on the inside (using a silicon carbide coating), resulting in a low output which is not sufficient for industrial application of the method and device. Furthermore, the method allows only single crystals of a limited thickness to be grown, since the crystal being grown, as it builds up the thickness, also grows on both sides, and the crystal that has filled the entire free space of the chamber can, obviously, be only extracted by cutting the chamber.

It is the object of the present invention to provide a method and reactor for growing bulk silicon carbide single crystal of a high quality required to produce semiconductor devices, while providing low production costs and a high output to ensure industrial application of the invention.

### SUMMARY OF THE INVENTION.

Under a first aspect of the invention said object is attained by a method according to claim 1, i.e. a method of growing monocrystalline silicon carbide by chemical vapor deposition on the growing surface of a substrate, comprising the heating of the walls of a chamber having at least one substrate mounted therein, allowing the temperature of the inner surface of the chamber to be maintained within a range of 1800°C to 2500°C, and the subsequent supply to the heated chamber of externally stored compound gaseous reagents containing silicon and carbon, wherein the silicon-containing compound gaseous reagent and the carbon-containing compound gaseous reagent are fed to the chamber separately, and are mixed in the vicinity of the growing surface of the substrate.

The separate supply of the reagents prevents the formation and growth of SiC deposits on the mouths of the ducts for feeding the reagents into the chamber, where a high vapor concentration of the mixture of atomic carbon and silicon would otherwise be reached, providing the predominance of deposition over sublimation of silicon carbide at the operating temperature of the chamber walls.

With the reagents fed separately, their mixing occurs at a substantial distance from the silicon-containing reagent feed duct mouth. The silicon drops formed at the initial stage of reagent decomposition have time enough to evaporate by virtue of a complete warm-up, as they travel as far as the mixing zone. This prevents interaction between the silicon drops and carbon resulting, in the formation of stable products, i.e. cluster whose deposition on the growing surface would lead to defects in the crystal being grown. Thus a high quality monocrystalline silicon carbide is produced by means of the separate reagent supply.

The substrate temperature is preferably maintained at a lower level than the chamber wall temperature.

Indeed, by controlling the reagent feed level, a vapor-phase silicon and carbon concentration in the chamber can be reached, such that the processes of silicon carbide deposition on the inner surface of the chamber and its sublimation at the operating temperature of the chamber walls are near equilibrium, with the sublimation process predominating, whereas it is the deposition process that is predominant on colder substrates, with the resultant growth of the deposited silicon carbide thereon.

The optimum values of the temperature difference between the chamber walls and the substrate range from 20°C to 90°C. Under such conditions, an intensive growth of the sublimation layer occurs at a rate of up to 1 mm/hr.

It is also preferred that the chamber be designed so as to allow insertion and withdrawal of the substrate through an opening in the chamber wall provided around the periphery of the substrate and spaced therefrom, further that inert gas be supplied to the chamber through the gap around the substrate, as the crystals are grown, and the substrate be drawn out of the chamber, as the thickness of the epitaxial layer grown increases so that, its growing surface is maintained on a level with the inner surface of the chamber wall.

In the course of growing, inert gas is fed through the gaps into the chamber. Substantially reducing the silicon-carbon vapor mixture concentration at the edges of the substrate, it prevents the size of the silicon carbide single crystal grown from being increased in width, allowing it to be pushed out of the chamber as it grows.

Thus a familiar limitation on the thickness of the bulk single crystal to be grown is overcome.

Also the substrate is preferably of a circular shape and is rotated about its axis perpendicular to the growing surface, as the silicon carbide single crystal is grown.

The substrate is rotated to improve the uniformity of growing the sublimation layers.

It is also preferred that monocrystalline silicon carbide be grown simultaneously on two substrates located opposite each other on the opposing walls of the chamber. In this case, most of the vapor-phase silicon carbide is deposited on the substrates.

It is further preferred that a solid solution of tantalum carbide and silicon carbide in tantalum be used as a material for the inner surface of the reactor chamber. Such surface is essentially free from wear and its properties do not change in the process of growing.

Under a second aspect of the invention the object is attained by a reactor according to claim 8, i.e. a reactor for growing monocrystalline silicon carbide by chemical vapor deposition on the growing surface of a substrate, said reactor comprising a chamber and at least one substrate, means for feeding into the chamber, from outside thereof, of compound gaseous reagents containing silicon and carbon respectively, and means for heating the walls of the chamber, allowing the temperature of the inner suface of the chamber to be maintained within a range of 1800°C to 2500°C, wherein the means for feeding the compound gaseous reagents comprise ducts for the supply into the chamber of the silicon-containing compound gaseous reagent apart from the carbon-containing compound gaseous reagent, the ducts being arranged so that the reagents are mixed in the vicinity of the substrate.

### BRIEF DESCRIPTION OF THE DRAWINGS

The invention is further illustrated by the description of its preferred embodiment, with reference to the accompanying drawings in which:
Fig. 1 represents a reactor for growing monocrystalline silicon carbide a longitudinal section, in the plane of the reagent feed duct;
Fig. 2 is a reactor, as represented in Fig. 1 a longitudinal section, along the line 2 - 2 of Fig. 1
Fig. 3 is a reactor, as represented in Fig. 1 a longitudinal section, along the line 3 - 3 of Fig. 1.

### DETAILED DESCRIPTION OF THE PREFERRED EMBODIMENT

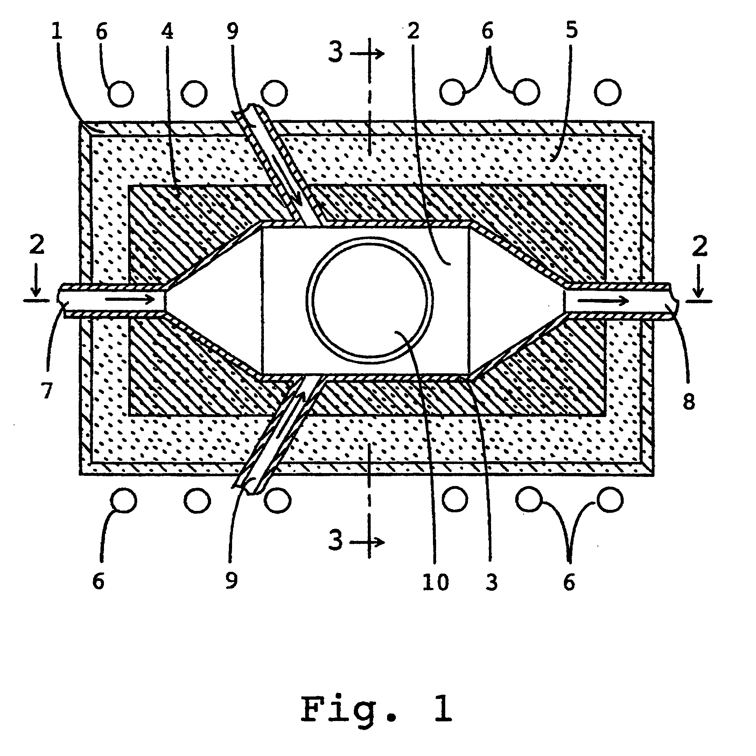

Monocrystalline silicon carbide is grown in a reactor represented in Fig. 1, which may be included, by convention, in a group of horizontal type reactors. Orientation of the reactor with respect to the direction of gravity force is of no importance for implementing the proposed invention.

The reactor comprises a cylindrical quartz casing 1 with a chamber 2 mounted therein and extending along the axis of the casing 1 coaxial therewith.

The chamber 2 comprises walls 3 made of sheet tantalum (Ta). The surface of the walls 3 defining the space of the chamber 2 is doped with carbon and silicon carbide.

The inner walls 3 are received by a susceptor 4 made of electrically conducting graphite. The inner space of the casing 1 surrounding the susceptor 4 is filled with a heat insulator 5 of porous graphite. Outside of the casing 1 an induction heater 6 is located adjusted to heat the susceptor 4 up to a temperature of 2500°C.

At one end the chamber 2 is connected with a duct 7 for feeding the silicon-containing reagent, and at the opposite end, with a duct 8 for removal of gaseous reaction products. The outlet of the duct 8 is connected with the means (not shown in the drawing) for evacuation of gaseous reaction products.

Entering the chamber 2, on its lateral sides, are ducts 9 serving to feed the carbon-containing reagent to the central portion of the chamber 2. Substrates 10 are positioned in the central portion of the chamber 2.

The outlets of the ducts 9 in the chamber 2 are so arranged that the carbon-containing reagent supplied to the chamber 2 through the ducts 9 and the silicon-containing reagent supplied through the duct 7 are mixed in the chamber 2 in close proximity to the substrates 10. The tilt of the ducts 9 relative to the chamber 2 axis, is designed to provide a component of the rate of flows of the carbon-containing reagent along the axis of the chamber 2 towards the duct 8, so as to prevent the carbon-containing reagent fed through the ducts 9 from coming within the region of the chamber 2 adjacent the outlet of the duct 7.

The reactor also includes the means (not shown) for controllable supply of both reagents to the chamber 2.

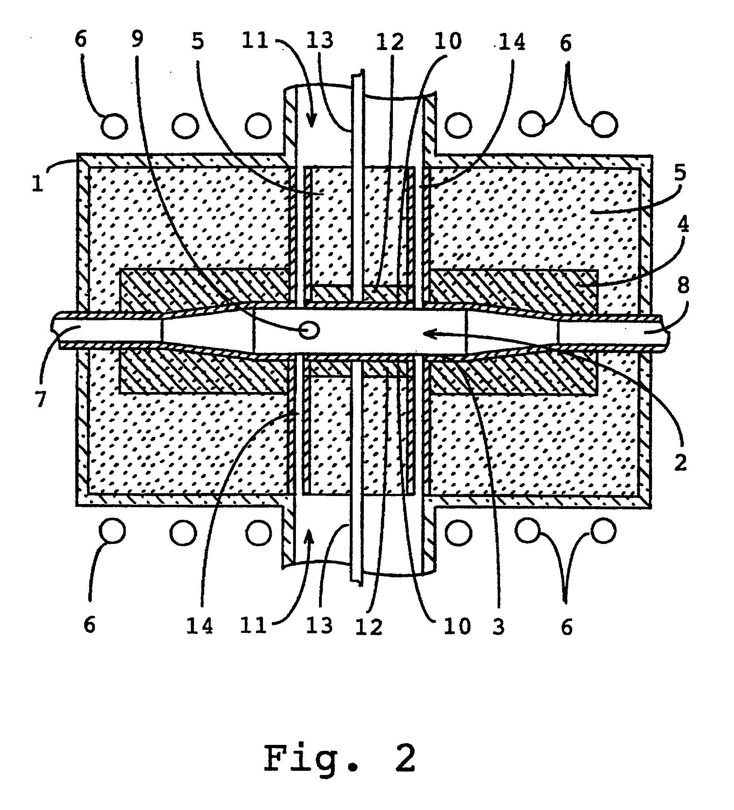

Fig. 2 illustrates the arrangement of the substrates 10 within the chamber 2.

In the central portion of the chamber 2, through its walls 3 and susceptor 4, there are provided, opposite each other, round holes 11 for insertion therethrough of the circular substrates 10. The substrates 10 are made of tantalum doped with carbon and silicon carbide, as described below, and mounted on wafers 12 composed of the same material as the susceptor 4.

The doping procedure for the walls 3 and the substrates 10 is run in two stages. At the first stage, the chamber 2 is filled with graphite powder and gradually heated, raising the temperature to 2200-2500°C and allowing it to stay for 1 to 3 hours. Graphite is then removed from the chamber 2 and, at the second stage, the first-stage conditions are repeated in the presence of silicon carbide within the space of the chamber 2. As a result of such doping, the inner surface of the chamber 2 acquires a high thermal stability, loses its ability to absorb silicon carbide vapors, and is not liable to attack by hydrogen at high temperatures.

The wafers 12 are coaxially secured to drive shafts 13. The shafts 13 are connected with the mechanisms (not shown) mounted outside the casing 1 and locked in position with respect thereto, these mechanisms being capable of transferring a rotary motion to the shafts 13 and, through them, to the substrates 10 and independently of this, a progressive motion along their axes. These mechanisms may be designed in a way similar to that employed in the well-known designs of drilling machines. For example, in order to transmit the rotary motion part of the shaft 13 may be in the form of a spline shaft, the independent progressive motion being provided by a carriage, which is connected with the shaft through a bearing. The inner surfaces of the upper and lower walls 3 of the chamber 2 are preferably made plane. The diameters of the holes 11 and the substrates 10 are so specified as to provide annular gaps 14 between the edges of the substrates 10 and the holes 11, their width being selected within a range of 0.001 to 0.01 of the substrate diameter. The reactor comprises the means (not shown) for controllable supply of inert gas, such as argon to the chamber through the gaps 14, these means being capable of isolating the inner space of the chamber 2 from the environment during the growth process.

The substrates 10 are located outside the zone of direct action of the induction heater 6 and are heated, primarily, from the surrounding heated walls 3 and of the chamber 2. The heat transfer from the susceptor 4 towards the substrates 10 is dependent on the thickness of the wafers 12, a temperature difference of 20-60°C between the heated walls 3 and the substrates 10 being achieved, at the initial stage of the growth, by an appropriate selection of the thickness.

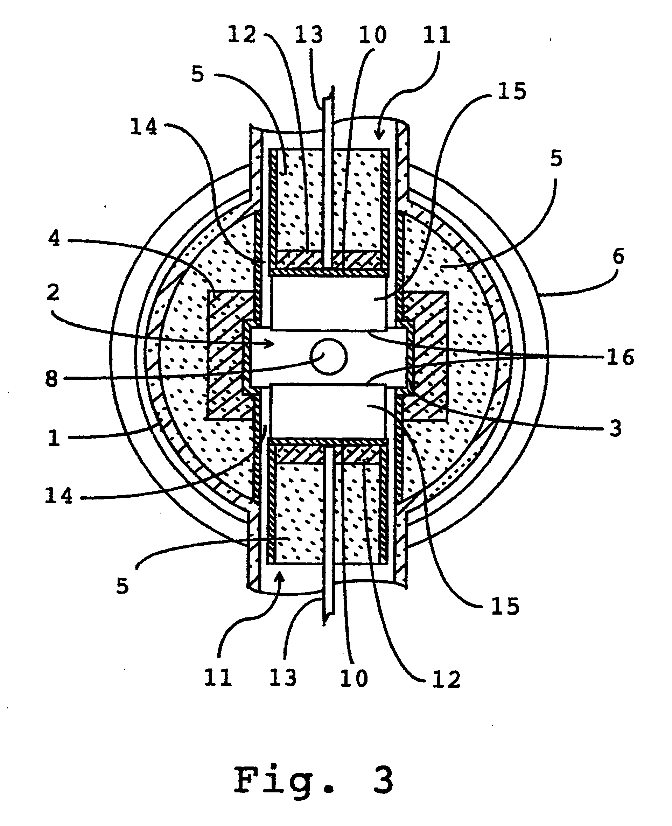

Fig. 3 shows a mutual arrangement of the reactor parts at that stage of the growing process where the silicon carbide single crystals 15 have already reached a considerable thickness. At this stage, the specified temperature of the growing surfaces 16 of the single crystals is maintained by the heated walls 3.

As will be apparent to those skilled in the art, in other embodiments of the present invention, the reactor chamber may have another configuration and a different arrangement and number of reagent feed ducts and may also include either one or more than two substrates, provided that the substrates are located adjacent one another, so that the reagents are mixed directly within the substrate area.

According to the invention, the monocrystalline silicon carbide is grown in the following manner.

Monocrystalline SiC seed films are secured to the substrates 10, the films being of the polytype to be grown. The substrates 10 are positioned in the holes 11 so that the growing surfaces of the seed single crystals are flush with the inner surfaces of the walls 3 of the chamber 2.

The inner space of the chamber 2 is isolated from the environment and heated by means of the induction heater 6. As the walls 3 of the chamber 2 are warmed up to the working temperature preferably set within a range of 2200°C to 2400°C, contaminants and undesirable impurities are removed by the blow-through, using hydrogen and, possibly, chlorine.

A silicon-containing gaseous reagent, such as silane (SiH₄) or chlorine-silane (SiH₂Cl₂), diluted with a carrier gas (hydrogen or helium), is fed to the chamber 2 through the duct 7. A carbon-containing reagent, such as propane (C₃H₈) or methane (C₂H₄), mixed with argon, hydrogen or helium, is fed to the chamber 2 through the ducts 9. Arrows on Figs. 1, indicate the directions of gas flows. The reagent mixing process is carried out at a substantial distance from the mouth of the silicon-containing reagent feed duct 7, and the silicon drops generated at an early stage of the reagent decomposition have time enough to evaporate by virtue of their being thoroughly warmed up on the way to the mixing zone. This prevents the silicon drops from reacting with carbon, which would bring about the formation of stable products, i.e. clusters, whose deposition onto the growing surface would lead to defects in the crystal grown, all this eventually resulting in quality silicon carbide single crystals.

The separate supply of the reagents prevents the formation and growth of silicon carbide deposits on the chamber walls in vicinity of the reagent mixture entrance, where a high concentration of vapors of the atomic carbon-silicon mixture would otherwise be reached, resulting in a predominance of deposition over sublimation of silicon carbide at the operating temperature. The proportion of reagents supplied to the chamber 2 per time unit is determined by the required ratio of silicon to carbon atoms being in the vapor phase in the vicinity of the growing surfaces of the single crystals after disintegration of the reagent molecules as a result of their being heated in the chamber 2. The optimum Si/C ratio is near unity.

By adjusting the reagent supply level, it is possible to achieve a concentration of the vapor-phase silicon and carbon in the chamber 2 such that the processes of depositing silicon carbide onto the inner surface of the chamber 2 and its sublimation at the operating temperature are near equilibrium, with the sublimation process being predominant. On the other hand, the deposition process predominates on colder substrates 10, and, here the monocrystalline silicon carbide growth occurs.

The substrates 10 are rotated at the rate of several revolutions per minute to contribute to a more uniform growth of the monocrystalline layer.

As the grown layer builds up, the substrates 10 are drawn out of the chamber 2, maintaining the growing surface of the single crystals in a stable position flush with the inner surface of the walls 3 adjacent the substrates 10. Since at a constant temperature of the chamber 2 and with the reagents uniformly fed thereto the epitaxial layer thickness growth rate remains constant, it will be enough to draw the substrates 10 out of the chamber at a constant rate determined by the results of experimental growth.

During the growth process, inert gas, such as argon or helium, is supplied through the gaps 14 to the chamber 2, which by substantially reducing concentration of the silicon and carbon vapor mixture prevents the expansion in width of the silicon carbide single crystal being grown, enabling it to be drawn out of the chamber 2 as it grows.

Thus an essential limitation on the thickness of the bulk single crystal grown, which is known in the art, is overcome.

Under such conditions, an intensive growth of the sublimation layer at a rate of up to 1 mm/hr occurs. In this case, most of silicon carbide is vapor deposited on the substrates 10, whereby the partial pressure of silicon and carbon vapors at the chamber 2 adjacent the outlet duct 8 proves to be substantially below the value permitting the deposits to be formed. As indicated above, the inner surface of the walls 3 made of tantalum doped with carbon and silicon carbide is, practically, not subject to wear, nor does it undergo any change of its properties as a result of the growth process.

Thus the aforementioned method of growing monocrystalline silicon carbide give quality product and is basically free from limitations imposed on the thickness of the crystals grown in a single cycle of continuous operation of the reactor. The reactor allows repeated cycles of growing to be run without undue expenses that would otherwise be incurred to recover its parts. Such combination of properties guarantees industrial application of the proposed invention.

Although there was no special discussion concerning the addition of dopants during the single crystal growth, the proposed invention permits application-specific doping of the silicon carbide single crystals being grown, including the case of alternating the layers containing different types of dopants.

## Claims

1. A method of growing monocrystalline silicon carbide by chemical vapor deposition on the growing surface of a substrate (10), comprising the heating of walls (3) of a chamber (2), with at least one substrate (10) mounted therein, allowing the temperature of inner surface of the chamber (2) to be maintained within a range of 1800°C to 2500°C, and the subsequent supply to the heated chamber (2) of externally stored compound gaseous reagents, containing silicon and carbon, respectively, **characterized in that** the silicon-containing compound gaseous reagent and the carbon-containing compound gaseous reagent are fed to the chamber (2) separately, and are mixed in the vicinity of the growing surface of the substrate (10).

2. The method of Claim 1 **characterized in that** the temperature of the substrate (10) is maintained at a lower level than that of the walls (3) of the chamber (2).

3. The method of Claim 2 **characterized in that** the temperature difference between the walls of the chamber (2) and the substrate (10) is maintained within the range or 20 - 60°C.

4. The method of Claim 3 **characterized in that** the chamber is designed so as to allow insertion thereto and withdrawal therefrom of the substrate (10) through a hole (11) provided in the wall (3) of the chamber (2) and spaced from the substrate (10) around the periphery thereof, with a gap (14), inert gas is fed to the chamber (2) through the gap (14) around the substrate (10) during the growth process, and the substrate (10) is drawn out of the chamber (2), as the thickness of the epitaxial layer of the single crystal increases, so that its growing surface is kept in a position flush with the edges of the hole (11) in the chamber (2).

5. The method of Claim 4 **characterized in that** the substrate (10) is made of a circular shape and as the silicon carbide single crystal is grown, it is rotated about its axis perpendicular to the growing surface.

6. The method of Claim 4 **characterized in that** the growing of the monocrystalline silicon carbide is carried out simultaneously on two substrates (10) located opposite each other on the opposing walls (3) of the chamber (2).

7. The method of Claim 1 **characterized in that** a solid solution of tantalum carbide and silicon carbide in tantalum is used as a material for the inner surface of the chamber (2).

8. A reactor for growing monocrystalline silicon carbide by chemical vapor deposition on the growing surface of a substrate, comprising a chamber (2), at least one substrate (10), means for feeding into the chamber, from outside thereof, of compound gaseous reagents containing silicon and carbon, respectively, and means for heating the walls (3) of the chamber (2), allowing the temperature of the inner surface of the chamber (2) to be maintained within a range of 1800°C to 2500°C, **characterized in that** the means for feeding compound gaseous reagents comprise ducts (7), (9) for the supply into the chamber (2) of the silicon-containing compound gaseous reagent apart from the carbon-containing compound gaseous reagent, the ducts (7), (9) being arranged so that the reagents are mixed in the vicinity of the substrate (10).

9. The reactor of Claim 8 **characterized in that** the chamber (2) is designed so as to allow insertion and withdrawal of the substrate (10) through a hole (11) provided in the wall (3) of the chamber (2) and spaced from the substrate (10) around the periphery thereof, with a gap (14), and the reactor comprises means for supplying inert gas to the chamber (2) through the gap (14) around the substrate (10).

10. The reactor of Claim 9 **characterized in that** the substrate (10) is of a circular shape and is made rotatable about its axis perpendicular to the growing surface, as the silicon carbide single crystal grows.

11. The reactor of Claim 10 **characterized in that** two substrates (10) are mounted in the chamber (2), facing each other on its opposing walls (3).

12. The reactor of Claim 8 **characterized in that** the inner surface of the chamber (2) is composed of a material representing a solid solution of tantalum carbide and silicon carbide in tantalum.

## Patentansprüche

1. Verfahren zum Züchten von monokristallinem Siliciumcarbid durch chemische Dampfabscheidung auf der Wachstumsoberfläche eines Substrats (10), das das Erhitzen von Wänden (3) einer Kammer (2) mit wenigstens einem darin montierten Substrat (10), so dass man die Temperatur der Innenoberfläche der Kammer (2) in einem Bereich von 1800°C bis 2500°C hält, sowie die anschließende Zufuhr von extern bereitgehaltenen Reagenzien in Form gasförmiger Verbindungen, die Silicium bzw. Kohlenstoff enthalten, in die erhitzte Kammer (2) umfaßt, **dadurch gekennzeichnet, dass** das Reagens in Form der siliciumhaltigen gasförmigen Verbindung und das Reagens in Form der kohlenstoffhaltigen gasförmigen Verbindung der Kammer (2) getrennt zugeführt werden und in der Nähe der Wachstumsoberfläche des Substrats (10) vermischt werden.

2. Verfahren nach Anspruch 1, **dadurch gekennzeichnet, dass** die Temperatur des Substrats (10) auf einem niedrigeren Niveau gehalten wird als dem der Wände (3) der Kammer (2).

3. Verfahren nach Anspruch 2, **dadurch gekennzeichnet, dass** der Temperaturunterschied zwischen den Wänden der Kammer (2) und dem Substrat (10) im Bereich von 20 bis 60°C gehalten wird.

4. Verfahren nach Anspruch 3, **dadurch gekennzeichnet, dass** die Kammer so aufgebaut ist, dass ein Einschieben des Substrats (10) in die Kammer und dessen Abziehen durch ein Loch (11) ermöglicht wird, das in der Wand (3) der Kammer (2) vorgesehen ist und um den Umfang des Substrats herum einen Abstand mit einem Spalt (14) aufweist, dass Inertgas der Kammer (12) durch den Spalt (14) um das Substrat (10) herum während des Züchtungsprozesses zugeführt wird, und das Substrat (10) aus der Kammer (2) abgezogen wird, wenn die Dicke der epitaxialen Schicht des Einkristalls zunimmt, so dass dessen wachsende Oberfläche in einer Ebene mit den Kanten des Lochs (11) in der Kammer (2) gehalten wird.

5. Verfahren nach Anspruch 4, **dadurch gekennzeichnet, dass** das Substrat (10) von kreisförmiger Form ist und dass es, während des Züchtens des Siliciumcarbid-Einkristalls, um seine Achse senkrecht zu der Wachstumsoberfläche rotiert wird.

6. Verfahren nach Anspruch 4, **dadurch gekennzeichnet, dass** das Züchten des monokristallinen Siliciumcarbids gleichzeitig auf zwei Substraten (10) durchgeführt wird, die einander gegenüberliegend an den gegenüberliegenden Wänden (3) der Kammer (2) angeordnet sind.

7. Verfahren nach Anspruch 1, **dadurch gekennzeichnet, dass** eine feste Lösung aus Tantalcarbid und Siliciumcarbid in Tantal als Material für die Innenoberfläche der Kammer (2) verwendet wird.

8. Reaktor zum Züchten von monokristallinem Siliciumcarbid durch chemische Dampfabscheidung auf der Wachstumsoberfläche eines Substrats, der eine Kammer (2), wenigstens ein Substrat (10), eine Einrichtung zur Zufuhr von Reagenzien in Form gasförmiger Verbindungen, die Silicium bzw. Kohlenstoff enthalten, von außerhalb der Kammer in die Kammer, sowie eine Einrichtung zum Erhitzen der Wände (3) der Kammer (2) umfaßt, die es ermöglicht, dass die Temperatur der Innenoberfläche der Kammer (2) in einem Bereich von 1800°C bis 2500°C gehalten wird, **dadurch gekennzeichnet, dass** die Einrichtung für die Zufuhr von Reagenzien in Form gasförmiger Verbindungen Leitungen (7), (9) für die Zufuhr des Reagens in Form der gasförmigen siliciumhaltigen Verbindung in die Kammer (2) getrennt von dem Reagens in Form der gasförmigen kohlenstoffhaltigen Verbindung umfasst, wobei die Leitungen (7), (9) so angeordnet sind, dass die Reagenzien in der Nähe des Substrats (10) vermischt werden.

9. Reaktor nach Anspruch 8, **dadurch gekennzeichnet, dass** die Kammer (2) so konstruiert ist, dass sie das Einschieben und das Abziehen des Substrats (10) durch ein Loch (11) ermöglicht, das in der Wand (3) der Kammer (2) vorgesehen ist und das um den Umfang des Substrats (10) herum einen Abstand mit einem Spalt (14) aufweist, und dass der Reaktor eine Einrichtung für die Zufuhr von Inertgas durch den Spalt (14) um das Substrat (10) herum in die Kammer umfaßt.

10. Reaktor nach Anspruch 9, **dadurch gekennzeichnet, dass** das Substrat (10) von kreisförmiger Gestalt ist und um seine Achse senkrecht zu der Wachstumsoberfläche rotierbar ausgeführt ist, während der Silicimcarbid Einkristall wächst.

11. Reaktor nach Anspruch 10, **dadurch gekennzeichnet, dass** zwei Substrate (10) in der Kammer (2) montiert sind, die sich an deren gegenüberliegenden Wänden (3) einander gegenüberliegen.

12. Reaktor nach Anspruch 8, **dadurch gekennzeichnet, dass** die Innenoberfläche der Kammer (2) aus einem Material zusammengestzt ist, das eine feste Lösung von Tantalcarbid und Siliciumcarbid in Tantal darstellt.

## Revendications

1. Procédé de culture de carbure monocristallin de silicium par dépôt chimique de vapeur sur la surface de croissance d'un substrat (10), qui comprend le chauffage de parois (3) d'une chambre (2), ayant au moins un substrat (10) monté à l'intérieur et permettant de maintenir la température de la surface intérieure de la chambre (2) dans une gamme de 1800°C à 2500°C, ainsi que l'introduction ultérieure de réactifs en forme de composés gazeux réservés à l'extérieur et contenant du silicium et du carbone, respectivement, dans la chambre réchauffée (2), **caractérisé en ce que** le réactif en forme de composé gazeux contenant du silicium et le réactif en forme de composé gazeux contenant du carbone sont introduits dans la chambre (2) séparément et se mélangent à proximité de la surface de croissance du substrat (10).

2. Procédé selon la revendication 1, **caractérisé en ce que** la température du substrat (10) est maintenue à un niveau plus bas que celle des parois (3) de la chambre (2).

3. Procédé selon la revendication 2, **caractérisé en ce que** la différence de température entre les parois de la chambre (2) et le substrat (10) est maintenue dans le domaine de 20-60°C.

4. Procédé selon la revendication 3, **caractérisé en ce que** la chambre est réalisée de manière qu'elle assure l'introduction et le retrait du substrat (10) par un orifice (11), dont la paroi (3) de la chambre (2) est munie et qui ménage un jeu (14) autour du périmètre du substrat (10), que, durant le processus de la croissance, du gaz inerte est introduit dans la chambre (2) par le jeu (14) ménagé autour du substrat (10), et que le substrat (10) est tiré de la chambre (2) à mesure que l'épaisseur de la couche epitaxiale du monocristal augmente de façon que la surface croissante de celui-ci soit maintenue au même niveau que les bords de l'orifice (11) dans la chambre (2).

5. Procédé selon la revendication 4, **caractérisé en ce que** le substrat (10) a une forme circulaire et est entrainé en rotation autour de son axe perpendiculaire à la surface de croissance à mesure que le carbure monocristallin de silicium croît.

6. Procédé selon la revendication 4, **caractérisé en ce que** le carbure monocristallin de silicium croît simultanément sur deux substrats disposés l'un en face de l'autre sur les parois opposées (3) de la chambre (2).

7. Procédé selon la revendication 1, **caractérisé en ce que** une solution solide de carbure de tantale et de carbure de silicium dans du tantale est utilisée comme matière de la surface intérieure de la chambre (2).

8. Réacteur pour faire croître du carbure monocristallin de silicium par dépôt chimique de vapeur sur la surface de croissance d'un substrat, comprennant une chambre (2), au moins un substrat (10), des moyens pour introduire dans la chambre, de l'extérieur de celle-ci, des réactifs en forme de composés gazeux contenant du silicium et du carbone et des moyens pour chauffer les parois (3) de la chambre (2) permettant de maintenir la température de la surface intérieure de la chambre (2) dans une domaine de 1800°C à 2500°C, **caractérisé en ce que** les dispositifs introduisant les réactifs en forme de composés gazeux possèdent des canaux (7), (9) afin d'introduire dans la chambre (2) le réactif en forme de composé gazeux contenant du silicium séparément du réactif en forme de composé gazeux contenant du carbone, les canaux (7), (9) étant arrangés de manière que les réactifs se mélangent à proximité du substrat (10).

9. Réacteur selon la revendication 8, **caractérisé en ce que** la chambre (2) est réalisée de manière qu'elle assure l'introduction et le retrait du substrat (10) par l'orifice (11) dont la paroi (3) de la chambre (2) est munie et qui ménage autour du périmètre du substrat un jeu (14), et que le réacteur possède des moyens pour introduire du gaz inerte dans la chambre (2) par le jeu (14) autour du substrat (10).

10. Réacteur selon la revendication 9, **caractérisé en ce que** le substrat (10) possède une forme circulaire et est agencé avec la possibilité de rotation autour de son axe perpendiculaire à la surface de croissance pendant que le carbure monocristallin du silicium croît.

11. Réacteur selon la revendication 10, **caractérisé en ce que** deux substrats (10) sont disposé dans la chambre l'un en face de l'autre sur les parois opposées (3) de la chambre (2).

12. Réacteur selon la revendication 8, **caractérisé en ce que** la surface intérieure de la chambre (2) est en une matière qui représente une solution solide de carbure de tantale et de carbure de silicium dans du tantale.
